# EUROPEAN PATENT SPECIFICATION

(11) **EP 2 015 092 B1**
(45) Date of publication and mention of the grant of the patent: **27.01.2010**
(21) Application number: 07013757.5
(22) Date of filing: 13.07.2007
(51) Int. Cl.: G01R 33/30

(54) **Mounting of instruments in an NMR spectrometer**
Montage von Instrumenten in einem NMR-Spektrometer
Montage d'instruments dans un spectromètre à RMN

(43) Date of publication of application: 14.01.2009
(73) Proprietor: Magnex Scientific Ltd., Yarnton, Oxford,OX5 1QU (GB)
(72) Inventor: Courtney, Alistair G., Oxford OX2 9LF (GB)
(74) Representative: Mollekopf, Gerd Willi

(56) References cited:
- EP-A- 0 165 741
- WO-A-2004/042414
- GB-A- 2 014 737
- BUTLER E: "AVANCE SGU Based Frequency Generation, Beginners Guide, Version 001" BEGINNERS GUIDE BRUKER, 27 June 2002 (2002-06-27), pages 1-18, XP002268875
- ANONYMOUS: "Varian Liquid State Probes" November 2003 (2003-11), VARIAN , PALO ALTO, USA , XP002461245 * pages 3,7,12 *

## Description

### FIELD OF THE INVENTION

The invention in general relates to nuclear magnetic resonance (NMR) spectroscopy, and in particular to NMR magnets and associated systems and methods for mounting NMR components such as shim coils to NMR magnets.

### BACKGROUND OF THE INVENTION

Nuclear magnetic resonance (NMR) spectrometers typically include a superconducting magnet for generating a static magnetic field B₀, and an NMR probe including one or more special-purpose radio-frequency (RF) coils for generating a time-varying magnetic field B₁ perpendicular to the field B₀, and for detecting the response of a sample to the applied magnetic fields. Each RF coil and associated circuitry can resonate at the Larmor frequency of a nucleus of interest present in the sample. The RF coils are typically provided as part of an NMR probe, and are used to analyze samples situated in sample tubes or flow cells. The direction of the static magnetic field B₀ is commonly denoted as the z-axis or longitudinal direction, while the plane perpendicular to the z-axis is commonly termed the x-y or transverse direction.

Generating high-resolution NMR spectra is facilitated by employing a temporally and spatially-homogeneous static magnetic field. The strength of the static magnetic field can vary over time due to temperature fluctuations or movement of neighboring metallic objects, among others. Spatial variations in the static magnetic field can be created by variations in sample tube or sample properties, the presence of neighboring materials, or by the magnet's design. Minor spatial inhomogeneities in the static magnetic field are ordinarily corrected using a set of shim coils, which generate a small magnetic field which opposes and cancels inhomogeneities in the applied static magnetic field.

The document EP-A-0 165 741 shows a nuclear magnetic resonance spectrometer comprising a vessel for housing a nuclear magnetic resonance magnet having an end cover and a side wall extending longitudinally from the end cover, the vessel including a longitudinal central bore extending through the end cover, a nuclear magnetic resonance instrument mounting bridge suspended across a central region of the end cover, and a nuclear magnetic resonance instrument assembly attached to a central region of the mounting bridge and positioned within the central bore of the vessel, the instrument assembly including a nuclear magnetic resonance probe.

The present invention seeks to provide an NMR spectrometer with a mounting bridge decoupled from any longitudinal flexing of the central part of the end cover of the vessel.

### SUMMARY OF THE INVENTION

The invention is defined in claims 1 and 12, respectively.

Particular embodiments are set out in the dependent claims.

According to some embodiments, the exemplary NMR instrument mounting systems and methods described below allow keeping the system shim coil assembly and the NMR probe in a fixed position relative to the magnet center by decoupling the coils from any flexing of a central region of the cryostat end cover (e.g. bottom plate) that may occur in response to environmental pressure variations.

### BRIEF DESCRIPTION OF THE DRAWINGS

The foregoing aspects and advantages of the present invention will become better understood upon reading the following detailed description and upon reference to the drawings where:

Fig. 1 is a schematic diagram of an exemplary NMR spectrometer according to some embodiments of the present invention.

Fig. **2** shows an isometric view of an NMR magnet cryostat and associated probe/shim coil mounting bridge according to some embodiments of the present invention.

Fig. **3** shows an isometric view of an NMR magnet cryostat and associated probe/shim coil mounting bridge according to some embodiments of the present invention.

Fig. **4** illustrates several system dimensions and other parameters according to some embodiments of the present invention.

Fig. **5-A** shows a mounting bridge attached to the side wall of an NMR magnet cryostat, according to some embodiments of the present invention.

Fig. **5-B** shows an NMR magnet cryostat having a domed end cover, according to some embodiments of the present invention.

### DETAILED DESCRIPTION OF THE INVENTION

In the following description, a set of elements includes one or more elements. Each recited element or structure can be formed by or be part of a monolithic structure, or be formed from multiple distinct structures. For example, a magnet vessel comprising an end cover and a longitudinal side wall may include an end cover fastened to the side wall, or a monolithic piece including an end cover integrally formed with a side wall. The statement that a mounting bridge is suspended over an end cover is not limited to orientations relative to the direction of gravity, and encompasses a mounting bridge positioned over or under the end cover relative to the direction of gravity. Unless otherwise specified, the term quasi-rectangular encompasses both perfectly rectangular shapes and quasi-rectangular shapes having rounded or otherwise non-linear sides. Unless otherwise specified, a magnet vessel end cover is not limited to structures situated at the top of a magnet vessel, but may include bottom or side plates, domes or other cover structures.

The following description illustrates embodiments of the invention by way of example and not necessarily by way of limitation.

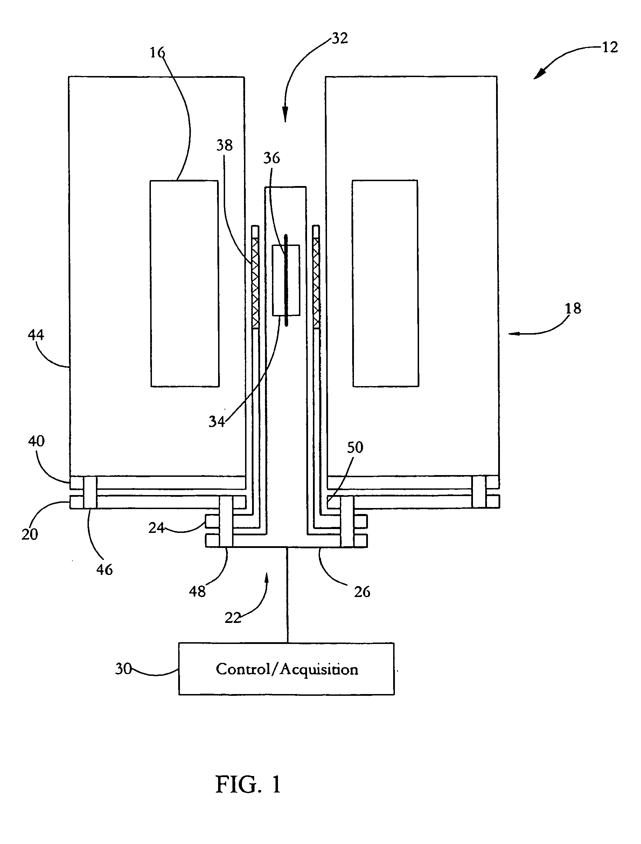

Fig. **1** is a schematic diagram illustrating an exemplary nuclear magnetic resonance (NMR) spectrometer **12** according to some embodiments of the present invention. Spectrometer **12** comprises a magnet **16** held within a vacuum vessel (cryostat) **18,** a rigid mounting bridge **20** attached to vessel **18,** an instrument assembly **22** including a shim coil assembly **24** and an NMR probe **26** attached to mounting bridge **20,** and a control/acquisition system (console) **30** electrically connected to instrument assembly **22.** Instrument assembly **22** is positioned in a cylindrical central bore **32** defined through vessel **18.**

Probe **26** includes one or more radio-frequency (RF) coils **34** and associated electrical circuit components. A sample container **36** is positioned within probe **26,** for holding an NMR sample of interest within coils **34** while measurements are performed on the sample. Sample container **36** can be a sample tube or a flow cell. A set of shim coils **38** laterally enclose RF coils **34.**

Vessel **18** may be a metallic cryostat having an external wall and one or more layered, vacuum-isolated internal walls accommodating cryogenic fluid(s) such as liquid nitrogen and/or liquid helium, for keeping the conductors of magnet **16** in a superconducting state. Magnet **16** is suspended in a fixed position within an internal chamber of vessel **18.** Vessel **18** includes an end cover **40** and a cylindrical side wall **44.** End cover **40** may be a flat (substantially planar) disk-shaped plate, for example a cryostat bottom plate. Side wall **44** extends longitudinally away from end cover **40** and is connected to end cover **40** along a perimeter of end cover **40.** End cover **40** is subject to a pressure difference: the pressure on the outer side of end cover **40** is generally atmospheric pressure, while the pressure on the inner side of end cover **40** is a significantly lower vacuum pressure. Mounting bridge **20** is rigidly attached to end cover **40** by a set of fasteners **46** situated along the perimeter of end cover **40,** away from central bore **32.** Mounting bridge **20** forms a bridge suspended between opposite sides of end cover **40,** and extending over central bore **32.** Shim coil assembly **24** and NMR probe **26** are rigidly attached to mounting bridge **20** by a set of fasteners **48** situated along a central region of mounting bridge **20.** Fasteners **46, 48** may be bolts or other fasteners. Mounting bridge **20** includes a central circular aperture **50** aligned with central bore **32.** Shim coil assembly **24** and NMR probe **26** pass through aperture **50** when shim coil assembly **24** and NMR probe **26** are secured within magnet **16.**

To perform a measurement, a sample is inserted into a measurement space defined within coils **34.** Magnet **16** applies a static magnetic field B₀ to the sample held within sample container **36.** Shim coils **38** are used to correct spatial inhomogeneities in the static magnetic field B₀. Control/acquisition system **30** comprises electronic components configured to apply desired radio-frequency pulses to probe **26,** and to acquire data indicative of the nuclear magnetic resonance properties of the samples within probe **26.** Coils **34** are used to apply radio-frequency magnetic fields B₁ to the sample, and/or to measure the response of the sample to the applied magnetic fields. The RF magnetic fields are perpendicular to the static magnetic field.

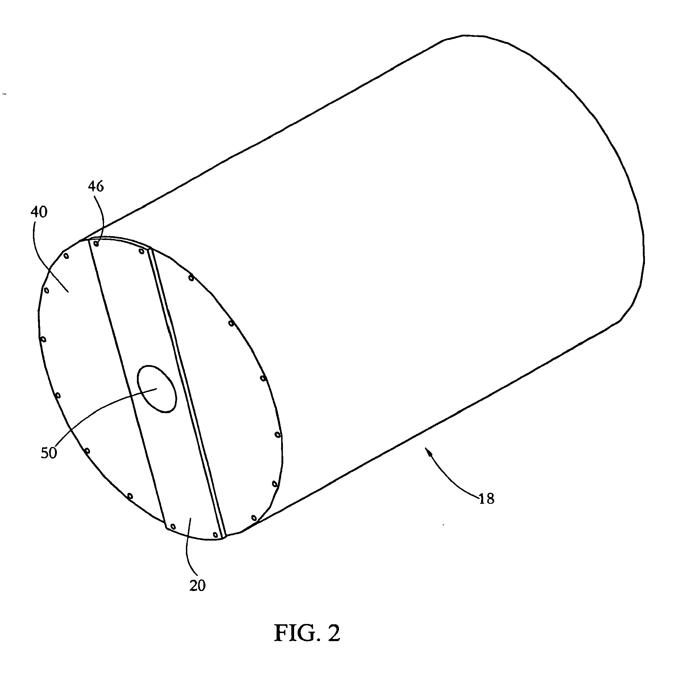

Fig. **2** shows an isometric view of vessel **18** and mounting bridge **20** according to some embodiments of the present invention. Mounting bridge **20** is formed by a quasi-rectangular central strip suspended at opposite ends between opposite sides of end cover **40.** Mounting bridge **20** is attached to end cover **40** through fasteners **46** situated at opposite ends of mounting bridge **20,** along the perimeter of end cover **40.** Mounting bridge **20** is not attached to end cover **40** along a central region Central aperture **50** accommodates NMR instruments inserted through the central bore of vessel **18.**

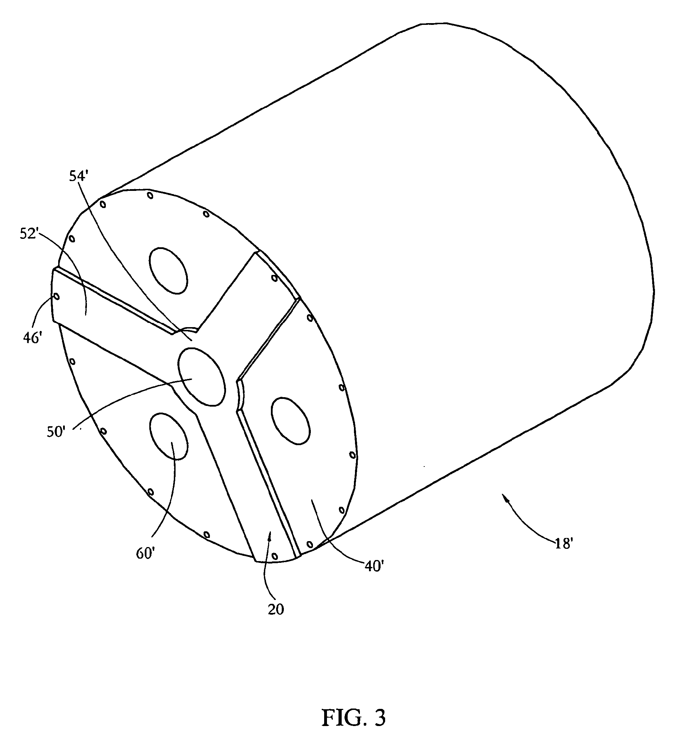

Fig. **3** shows an isometric view of a NMR magnet vessel **18'** and associated probe/shim coil mounting bridge **20'** according to some embodiments of the present invention. Mounting bridge **20'** includes three radial arms **52'** extending between a central annular region **54'** and a perimeter of an end cover **40'** of vessel **18'.** Mounting bridge **20'** is secured to end cover **40'** by fasteners **46'** situated at the distal ends of arms **52',** and is not secured to end cover **40'** along annular region **54'.** A central aperture **50'** defined in annular region **54'** accommodates NMR instruments inserted through a central bore of vessel **18'.** Vessel **18'** includes three apertures **60',** which may be used for transport fixtures and/or a pressure relief safety valve. Transport fixtures may be used to secure vessel **18'** during transport. The mounting bridge design of Fig. **3** may be more costly to fabricate than the rectangular-cover design of Fig. **2****.** At the same time, the mounting bridge design of Fig. **3** may allow improved access to apertures **60'.** A rectangular-cover design such as the one shown Fig. **2** may obstruct access to apertures **60'** if the mounting bridge is sufficiently wide relative to the spacings between apertures **60'.**

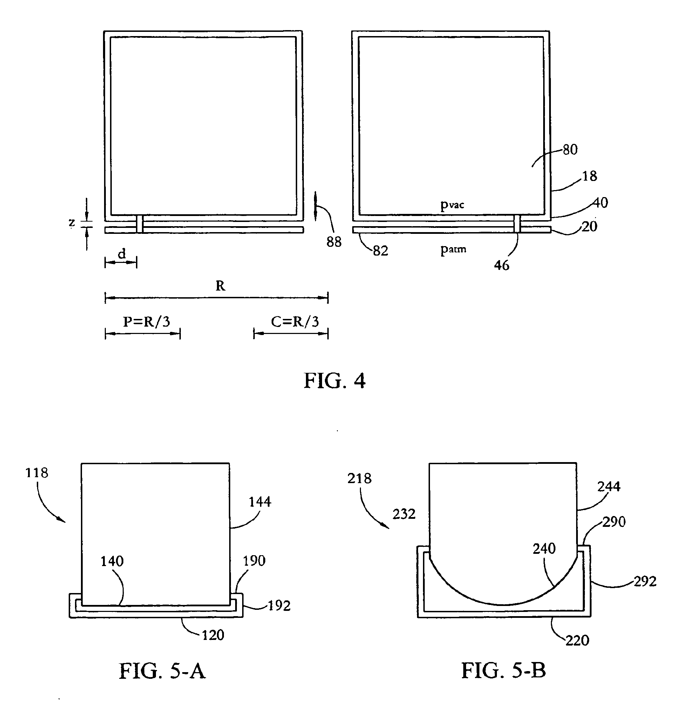

Fig. **4** illustrates several system dimensions and other parameters according to some embodiments of the present invention. The end cover size *R* denotes the radius of end cover **40** (or more generally, half the transverse extent of end cover **40),** while a connection distance *d* denotes the distance between the outer edge of end cover **40** and the inner-most attachment point(s) of mounting bridge **20** to end cover **40.** An inner chamber **80** formed on the inner side of end cover **40** has an internal vacuum pressure *p_{vac}*, while the outside of end cover **40** is at an atmospheric pressure pₐₜₘ. Both sides (top and bottom) of mounting bridge 20 are at atmospheric pressure. The connection distance *d* is preferably chosen so that a central part **82** of mounting bridge **20** is decoupled from any longitudinal flexing of the central part of end cover **40** resulting from variations in the pressure difference across end cover **40.** Central part **82** serves as an attachment region for attaching NMR instruments to mounting bridge **20.** The longitudinal flexing of end cover **40** is schematically illustrated in Fig. **4** by arrow **88.** A longitudinal separation z between end cover **40** and mounting bridge **20** is chosen to be sufficient so that end cover **40** does not touch mounting bridge **20** as end cover **40** flexes longitudinally in response to environmental pressure changes.

A peripheral region of end cover **40** and mounting bridge **20** may be defined by a radial extent P = R/3 from the perimeter of end cover **40,** while a central region of end cover **40** and mounting bridge may be defined by a radial extent C = R/3 from the center of end cover **40** and mounting bridge **20.** Preferably, the innermost point of attachment between mounting bridge **20** and end cover **40** is within the peripheral region, and mounting bridge **20** is suspended over the central region of end cover **40** and is substantially decoupled from any longitudinal motion of the central region of end cover **40.**

In some embodiments, the connection distance *d* is chosen to be as small as mechanically feasible, and fasteners **46** are situated substantially along the perimeter of end cover **40.** In some embodiments, the connection distance may be chosen to be much smaller than *R*, for example less than R/3, or preferably less than R/10. In exemplary embodiments, the end cover radius *R* may be on the order of tens of cm to 1 m, while the connection distance *d* may be on the order of several mm or cm. The longitudinal separation *z* may be on the order of a mm or less.

Fig. **5-A** shows a mounting bridge **120** attached to a side wall **144** of an NMR magnet vessel **118.** Mounting bridge **120** is attached to side wall **144** along the perimeter of a planar end cover **140.** Radial and longitudinal extensions **190, 192** connect mounting bridge **120** to side wall **144.** Extensions **190, 192** may be formed by a set of arms or continuous disk-shaped or cylinder-shaped plates/shells, respectively.

Fig. **5-B** shows a mounting bridge **220** attached to a side wall **244** of an NMR magnet vessel **218.** Vessel **218** has a domed end cover **240.** Mounting bridge **220** is attached to a side wall **244** of vessel **218** along the perimeter of end cover **240.** Radial and longitudinal extensions **290, 292** connect mounting bridge **220** to side wall **244.** A longitudinal central bore **230** extends through the center (tip of the dome) of end cover **240.**

It was observed that some NMR systems may be subject to shimming difficulties. Optimal shimming generally depends on precise and stable alignment of the shim coils with respect to the center of the magnet. It was observed that in some NMR cryostats, the end cover(s) may act as diaphragms in response to changes in environmental parameters such as atmospheric pressure, causing slight longitudinal deflections in the positions of the shim coils and/or NMR RF coils relative to the magnet center. While such deflections may be generally small, and are believed to be typically substantially smaller than about 1 mm, they may interfere with the operation of NMR instruments, which depend on the precise alignment of the shim and/or RF coils to the magnet center. The end cover deflections may be particularly pronounced in systems having flat end plates.

Using mounting bridges and/or attachment mechanisms as described above allows substantially decoupling the shim coil and/or **RF** coil positions from any flexing of the cryostat end cover that results from variations in atmospheric pressure, and thus in the pressure differential across the end cover. Attaching the mounting bridge to the cryostat away from the center of the end cover diaphragm allows minimizing the coupling of the mounting bridge to any end cover motion. The exemplary mounting systems and methods described above may be used in conjunction with or instead of other techniques for stabilizing the position of the shim and/or RF coils relative to the magnet center. Such techniques may include using domed or shaped end covers, using stiffer and/or thicker end cover materials, and adding mechanical reinforcement to the end cover.
According the invention, a suspended mounting bridge is used to attach a nuclear magnetic resonance (NMR) instrument assembly including a shim coil assembly and an NMR probe to a vessel for housing an NMR magnet. The mounting bridge is suspended across a central region of an end cover (e.g. bottom plate) of the vessel which can be a cryostat. Consequently, flexing of the end cover center in response to changes in environmental pressure does not cause displacement of the shim coils and/or RF coils relative to the NMR magnet center. The mounting bridge may be attached to a peripheral region of the end cover (e.g. along its perimeter), and/or to a cryostat side wall. The mounting bridge may be shaped as a quasi-rectangular strip or may include multiple spokes.

The above embodiments may be altered in many ways without departing from the scope of the invention. For example, the end cover described above may be a top, bottom, or side cover. Mounting bridge shapes other than the ones shown in Figs. **2** and **3** may be used. Such shapes may include a single cantilevered arm or multiple arms attached at one or more points to a cryostat top/bottom cover, or a vented circular cover (a false end cover) parallel to the cryostat top/bottom cover and subject to atmospheric pressure on both sides. An NMR instrument assembly may include shim and RF coils commonly attached to a mounting bridge, or separately attached to the mounting bridge. For example, shim coils may be provided outside or within an NMR probe. In some embodiments, the mounting bridge need not be attached directly to the end cover, but may be attached to another rigid structure (e.g. a rigid ring) mounted on the end cover. Similarly, in some embodiments the NMR instrument assemblies need not be mounted directly on the mounting bridge, but generally may be mounted on a flange or other rigid structure attached to the mounting bridge. Accordingly, the scope of the invention should be determined by the following claims and their legal equivalents.

## Claims

1. A nuclear magnetic resonance spectrometer (12) comprising:
a vessel (18) for housing a nuclear magnetic resonance magnet having an end cover (40) and a side wall (44) extending longitudinally from the end cover, the vessel including a longitudinal central bore (32) extending through the end cover (40);
a nuclear magnetic resonance instrument mounting bridge (20) attached to a peripheral region of the magnet vessel (18) and suspended across a central region of the end cover (40) such that deflections of the central region of the end cover (40) do not lead to deflections of a central region of the mounting bridge (20); and
a nuclear magnetic resonance instrument assembly (22) attached to the central region of the mounting bridge (20) and positioned within the central bore (32) of the vessel (18), the instrument assembly (22) including a shim coil assembly (24) and an NMR probe (26).

2. The spectrometer of claim 1, wherein the shim coil assembly (24) includes one or more shim coils (38).

3. The spectrometer of claim 1 or 2, wherein the mounting bridge (20) is attached to the vessel (18) along a peripheral region of the end cover (40), wherein the peripheral region is defined by a radial extend of R/3 from the perimeter of the end cover (40), R being the end cover radius.

4. The spectrometer of claim 3, wherein a distance (d) between an innermost mounting bridge-vessel attachment point and the perimeter of the end cover (40) is less than 10% of the radius R of the end cover.

5. The spectrometer of claim 3, wherein the mounting bridge (20) is fastened directly to the end cover (40).

6. The spectrometer of claim 1, or 2, wherein the mounting bridge (20) is attached to the vessel (18) along the side wall (44) and/or is attached to the vessel (18) along the perimeter of the end cover (40).

7. The spectrometer of any of the preceding claims, wherein the mounting bridge (20) comprises a central aperture (50) co-centered with the central bore (32) of the vessel (18).

8. The spectrometer of any of the preceding claims, wherein the mounting bridge (20) comprises a quasi-rectangular plate extending substantially along a diameter of the end cover (40).

9. The spectrometer of any of the preceding claims 1 to 7, wherein the mounting bridge (20) comprises at least three radial spokes (52') each extending between the central region of the end cover (40) and the perimeter of the end cover.

10. The spectrometer of any of the preceding claims, wherein the end cover (40) is formed by a flat plate.

11. The spectrometer of any of the preceding claims, wherein the vessel (18) is a cryostat having an evacuated internal chamber on an internal side of the end cover (40).

12. A method comprising:
suspending a nuclear magnetic resonance instrument mounting bridge (20) across a central region of an end cover (40) of a vessel (18) for housing a nuclear magnetic resonance magnet by attaching the mounting bridge (20) to a peripheral region of the magnet vessel (18) such that deflections of the central region of the end cover (40) do not lead to deflections of a central region of the mounting bridge (20), the vessel including a longitudinal central bore (32) extending through the end cover (40); and
attaching a nuclear magnetic resonance instrument assembly (22) to the central region of the mounting bridge (20) to position the nuclear magnetic instrument assembly (22) within the central bore (32), the instrument assembly including a shim coil assembly (24) and an NMR probe (26).

13. The method of claim 12, wherein the shim coil assembly (24) includes one or more shim coils (38).

14. The method of claim 12 or 13, comprising attaching the mounting bridge (20) to the vessel (18) along a peripheral region of the end cover (40), along a side wall (44) of the vessel, and/or along a perimeter of the end cover (40), wherein the peripheral region of the end cover (40) is defined by a radial extend of R/3 from the perimeter of the end cover (40), R being the end cover radius.

15. The method of any of claims 12 to 14, comprising co-centering a central aperture (50) of the mounting bridge (20) with the central bore (32) of the vessel (40).

16. The method of any of claim 12 to 15, wherein the end cover (40) is formed by a flat plate.

17. The method of any of claims 12 to 16, wherein the vessel (18) is a cryostat having a vacuum-pressure internal chamber on an internal side of the end cover (40).

## Patentansprüche

1. Ein Kernspinresonanzspektrometer (12), das aufweist:
ein Gefäß (18), zum Aufnehmen eines Kernspinresonanzmagneten, mit einer Endabdeckung (40) und einer Seitenwand (44), die sich von der Endabdeckung her in Längsrichtung erstreckt, wobei das Gefäß eine längslaufende Mittenbohrung (32) einschließt, die sich durch die Endabdeckung (40) erstreckt;
eine Kernspinresonanzinstrumenten-Montagebrücke (20), die an einem peripheren Bereich des Magnetgefäßes (18) angebracht ist und über einen Mittenbereich der Endabdeckung (40) aufgehängt ist, so dass Auslenkungen des Mittenbereichs der Endabdeckung (40) nicht zu Auslenkungen eines Mittenbereichs der Montagebrücke (20) führen; und
eine Kernspinresonanzinstrumenten-Anordnung (22), die am Mittenbereich der Montagebrücke (20) angebracht ist und innerhalb der Mittenbohrung (32) des Gefäßes (18) positioniert ist, wobei die Instrumenten-Anordnung (22) eine Kompensationsspulenanordnung (24) und einen NMR Probenkopf (26) einschließt.

2. Das Spektrometer nach Anspruch 1, wobei die Kompensationsspulenanordnung (24) eine oder mehrere Kompensationsspulen (38) einschließt.

3. Das Spektrometer nach Anspruch 1 oder 2, wobei die Montagebrücke (20) am Gefäß (18) entlang eines peripheren Bereichs der Endabdeckung (40) angebracht ist, wobei der periphere Bereich durch eine radiale Ausdehnung von R/3 vom Perimeter der Endabdeckung (40) her festgelegt ist, wobei R der Radius der Endabdeckung ist.

4. Das Spektrometer nach Anspruch 3, wobei ein Abstand (d) zwischen einem innersten Befestigungspunkt Montagebrücke-Gefäß und dem Perimeter der Endabdeckung (40) weniger als 10% des Radius R der Endabdeckung beträgt.

5. Das Spektrometer nach Anspruch 3, wobei die Montagebrücke (20) direkt an der Endabdeckung (40) befestigt ist.

6. Das Spektrometer nach Anspruch 1 oder 2, wobei die Montagebrücke (20) am Gefäß (18) entlang der Seitenwand (44) angebracht ist und/oder am Gefäß (18) entlang des Perimeters der Endabdeckung (40) angebracht ist.

7. Das Spektrometer nach einem der vorhergehenden Ansprüche, wobei die Montagebrücke (20) eine Mittenöffnung (50) aufweist, die zur Mittenbohrung (32) des Gefäßes (18) zentriert ist.

8. Das Spektrometer nach einem der vorhergehenden Ansprüche, wobei die Montagebrücke (20) eine quasi-rechteckige Platte aufweist, die sich im Wesentlichen entlang eines Durchmessers der Endabdeckung (40) erstreckt.

9. Das Spektrometer nach einem der vorhergehenden Ansprüche 1 bis 7, wobei die Montagebrücke (20) zumindest drei radiale Speichen (52') aufweist, wobei sich jede zwischen dem Mittenbereich der Endabdeckung (40) und dem Perimeter der Endabdeckung erstreckt.

10. Das Spektrometer nach einem der vorhergehenden Ansprüche, wobei die Endabdeckung (40) durch eine flache Platte ausgebildet ist.

11. Das Spektrometer nach einem der vorhergehenden Ansprüche, wobei das Gefäß (18) ein Kryostat mit einer evakuierten Innenkammer auf einer Innenseite der Endabdeckung (40) ist.

12. Ein Verfahren, das aufweist:
Aufhängen einer Kernspinresonanzinstrumenten-Montagebrücke (20) über einen Mittenbereich einer Endabdeckung (40) eines Gefäßes (18) zum Aufnehmen eines Kernspinresonanzmagneten durch Anbringen der Montagebrücke (20) an einem peripheren Bereich des Magnetgefäßes (18), so dass Auslenkungen des Mittenbereichs der Endabdeckung (40) nicht zu Auslenkungen eines Mittenbereichs der Montagebrücke (20) führen, wobei das Gefäß eine längslaufende Mittenbohrung (32) einschließt, die sich durch die Endabdeckung (40) erstreckt; und
Anbringen einer Kernspinresonanzinstrumenten-Anordnung (22) am Mittenbereich der Montagebrücke (20), um die Kernspinresonanzinstrumenten-Anordnung (22) innerhalb der Mittenbohrung (32) zu positionieren, wobei die Instrumenten-Anordnung eine Kompensationsspulenanordnung (24) und einen NMR Probenkopf (26) einschließt.

13. Das Verfahren nach Anspruch 12, wobei die Kompensationsspulenanordnung (24) eine oder mehrere Kompensationsspulen (38) einschließt.

14. Das Verfahren nach Anspruch 12 oder 13, das ein Anbringen der Montagebrücke (20) am Gefäß (18) entlang eines peripheren Bereichs der Endabdeckung (40), entlang einer Seitenwand (44) des Gefäßes und/oder entlang eines Perimeters der Endabdeckung (40) aufweist, wobei der periphere Bereich der Endabdeckung (40) durch eine radiale Ausdehnung von R/3 vom Perimeter der Endabdeckung (40) her festgelegt ist, wobei R der Radius der Endabdeckung ist.

15. Das Verfahren nach einem der Ansprüche 12 bis 14, das ein Zentrieren einer Mittenöffnung (50) der Montagebrücke (20) zur Mittenbohrung (32) des Gefäßes (40) aufweist.

16. Das Verfahren nach einem der Ansprüche 12 bis 15, wobei die Endabdeckung (40) durch eine flache Platte ausgebildet ist.

17. Das Verfahren nach einem der Ansprüche 12 bis 16, wobei das Gefäß (18) ein Kryostat mit einer Vakuumdruck-Innenkammer auf einer Innenseite der Endabdeckung (40) ist.

## Revendications

1. Spectromètre à résonance magnétique nucléaire (12) comprenant :
un récipient (18) destiné à loger un aimant de résonance magnétique nucléaire comportant un couvercle d'extrémité (40) et une paroi latérale (44) s'étendant longitudinalement depuis le couvercle d'extrémité, le récipient comprenant un alésage central longitudinal (32) s'étendant à travers le couvercle d'extrémité (40),
un pont de montage d'instrument de résonance magnétique nucléaire (20) fixé à une région périphérique du récipient pour aimant (18) et suspendu à travers une région centrale du couvercle d'extrémité (40) de sorte que des flexions de la région centrale du couvercle d'extrémité (40) ne conduisent pas à des flexions d'une région centrale du pont de montage (20), et
un ensemble d'instrument de résonance magnétique nucléaire (22) fixé à la région centrale du pont de montage (20) et positionné à l'intérieur de l'alésage central (32) du récipient (18), l'ensemble d'instrument (22) comprenant un ensemble de bobines de correction (24) et une sonde de résonance RMN (26).

2. Spectromètre selon la revendication 1, dans lequel l'ensemble de bobines de correction (24) comprend une ou plusieurs bobines de correction (38).

3. Spectromètre selon la revendication 1 ou 2, dans lequel le pont de montage (20) est fixé au récipient (18) le long d'une région périphérique du couvercle d'extrémité (40), où la région périphérique est définie par l'extension radiale de R/3 depuis le périmètre du couvercle d'extrémité (40), R étant le rayon du couvercle d'extrémité.

4. Spectromètre selon la revendication 3, dans lequel la distance (d) entre un point de fixation pont de montage - récipient le plus à l'intérieur et le périmètre du couvercle d'extrémité (40) est inférieure à 10 % du rayon R du couvercle d'extrémité.

5. Spectromètre selon la revendication 3, dans lequel le pont de montage (20) est fixé directement au couvercle d'extrémité (40).

6. Spectromètre selon la revendication 1 ou 2, dans lequel le pont de montage (20) est fixé au récipient (18) le long de la paroi latérale (44) et/ou est fixé au récipient (18) le long du périmètre du couvercle d'extrémité (40).

7. Spectromètre selon l'une quelconque des revendications précédentes, dans lequel le pont de montage (20) comprend une ouverture centrale (50) centrée conjointement avec l'alésage central (32) du récipient (18).

8. Spectromètre selon l'une quelconque des revendications précédentes, dans lequel le pont de montage (20) comprend une plaque quasi rectangulaire s'étendant sensiblement le long d'un diamètre du couvercle d'extrémité (40).

9. Spectromètre selon l'une quelconque des revendications précédentes 1 à 7, dans lequel le pont de montage (20) comprend au moins trois rayons radiaux (52') s'étendant chacun entre la région centrale du couvercle d'extrémité (40) et le périmètre du couvercle d'extrémité.

10. Spectromètre selon l'une quelconque des revendications précédentes, dans lequel le couvercle d'extrémité (40) est formé par une plaque plate.

11. Spectromètre selon l'une quelconque des revendications précédentes, dans lequel le récipient (18) est un cryostat comportant une chambre interne mise sous vide sur un côté interne du couvercle d'extrémité (40).

12. Procédé comprenant les étapes consistant à :
suspendre un pont de montage d'instrument de résonance magnétique nucléaire (20) à travers une région centrale d'un couvercle d'extrémité (40) d'un récipient (18) pour loger un aimant de résonance magnétique nucléaire en fixant le pont de montage (20) à une région périphérique du récipient pour aimant (18) de sorte que des flexions de la région centrale du couvercle d'extrémité (40) ne conduisent pas à des flexions d'une région centrale du pont de montage (20), le récipient comprenant un alésage central longitudinal (32) s'étendant à travers le couvercle d'extrémité (40), et
fixer un ensemble d'instrument de résonance magnétique nucléaire (22) à la région centrale du pont de montage (20) pour positionner l'ensemble d'instrument de résonance magnétique nucléaire (22) à l'intérieur de l'alésage central (32), l'ensemble d'instrument comprenant un ensemble de bobines de correction (24) et une sonde de résonance RMN (26).

13. Procédé selon la revendication 12, dans lequel l'ensemble de bobines de correction (24) comprend une ou plusieurs bobines de correction (38).

14. Procédé selon la revendication 12 ou 13, comprenant la fixation du pont de montage (20) au récipient (18) le long d'une région périphérique du couvercle d'extrémité (40), le long d'une paroi latérale (44) du récipient et/ou le long d'un périmètre du couvercle d'extrémité (40), où la région périphérique du couvercle d'extrémité (40) est définie par une extension radiale de R/3 depuis le périmètre du couvercle d'extrémité (40), R étant le rayon du couvercle d'extrémité.

15. Procédé selon l'une quelconque des revendications 12 à 14, comprenant le centrage conjoint d'une ouverture centrale (50) du pont de montage (20) avec l'alésage central (32) du récipient (18).

16. Procédé selon l'une quelconque des revendications 12 à 15, dans lequel le couvercle d'extrémité (40) est formé par une plaque plate.

17. Procédé selon l'une quelconque des revendications 12 à 16, dans lequel le récipient (18) est un cryostat comportant une chambre interne à la pression du vide sur un côté interne du couvercle d'extrémité (40).
